(19) **Europäisches Patentamt**

**European Patent Office**

**Office européen des brevets**

(11) **EP 0 678 978 B1**

(12) **EUROPÄISCHE PATENTSCHRIFT**

(45) Veröffentlichungstag und Bekanntmachung des Hinweises auf die Patenterteilung:
**08.08.2001  Patentblatt 2001/32**

(51) Int Cl.⁷: **H03H 11/12**

(21) Anmeldenummer: **95200908.2**

(22) Anmeldetag: **11.04.1995**

(54) **Schaltungsanordnung mit einem einstellbaren Amplituden-Frequenzgang**

Circuit with adjustable frequency response

Circuit avec une réponse en fréquences ajustables

(84) Benannte Vertragsstaaten:
**DE FR GB**

(30) Priorität: **21.04.1994  DE 4413928**

(43) Veröffentlichungstag der Anmeldung:
**25.10.1995  Patentblatt 1995/43**

(73) Patentinhaber:
• **Philips Corporate Intellectual Property GmbH**
**52064 Aachen (DE)**
Benannte Vertragsstaaten:
**DE**
• **Koninklijke Philips Electronics N.V.**
**5621 BA Eindhoven (NL)**
Benannte Vertragsstaaten:
**FR GB**

(72) Erfinder: **Dick, Burkhard**
**D-20097 Hamburg (DE)**

(74) Vertreter: **Peters, Carl Heinrich, Dipl.-Ing. et al**
**Philips Corporate Intellectual Property GmbH,**
**Habsburgerallee 11**
**52064 Aachen (DE)**

(56) Entgegenhaltungen:
**DE-A- 2 815 671**

• **PATENT ABSTRACTS OF JAPAN vol. 012, no. 177 (E-613), 25.Mai 1988 & JP-A-62 285508 (SONY CORP), 11.Dezember 1987,**

**Beschreibung**

Die Erfindung bezieht sich auf eine Schaltungsanordnung mit einem einstellbaren Amplituden-Frequenzgang zwischen einem Eingang, dem ein Eingangssignal zuführbar ist, und einem Ausgang zum Abgreifen eines Ausgangssignals.

Aus der DE-PS 25 37 140 ist ein Verfahren zur Korrektur des Amplitudengangs eines mit Frequenzmodulation betriebenen Rundfunkkanals eines Richtfunksystems ohne störenden Einfluß auf den Frequenzgang seines Phasenverlaufs bzw. des direkt damit verknüpften Verlaufs der Gruppenlaufzeit bekannt, wobei überbrückte T-Glieder als Allpaß Verwendung finden. Bei diesem Verfahren wird zur Entzerrung des Dämpfungsverlaufs des vorhandenen Laufzeitentzerrers im Übertragungsband abweichend von der für einen idealisierten Allpaß mit verlustfreien Elementen üblichen Dimensionierung mit konstantem Verlauf der Dämpfung über der Frequenz diese konstante Dämpfung so parabelförmig nach kleineren Werten hin unterschritten, daß der Grad der Parabel dem Grad der Verzerrung entspricht. Mit einer solchen Anordnung wird jedoch nur eine annähernde Unabhängigkeit des Phasenverlaufs vom Amplitudengang nur für eine feste Amplitude und eine feste Amplitudencharakteristik erreicht, und zwar für sogenannte Allpässe.

Aus der EP-PS 11 446 ist eine Schaltung mit einer einstellbaren Frequenzkennlinie bekannt, welche eine erste Filterschaltung, einen ersten Verstärker zum Verstärken des Ausgangssignals der Filterschaltung, einen zweiten Verstärker zum Verstärken eines Signals, das als Differenz zwischen Eingangs- und Ausgangssignal der Filterschaltung gebildet ist, und einen Addierer, der die Ausgangssignale des ersten und des zweiten Verstärkers addiert, umfaßt. Bei dieser bekannten Schaltung ist weiterhin vorgesehen, daß die Filterschaltung einen Kondensator und einen Verstärker mit variablem Verstärkungsfaktor enthält, daß wenigstens der erste oder zweite Verstärker ein Verstärker mit variablem Verstärkungsfaktor ist und daß außerdem Mittel zur Erzeugung eines Verstärkungsfaktorsteuersignals vorgesehen sind, die mit dem ersten und/oder dem zweiten Verstärker, welcher als Verstärker mit variablem Verstärkungsfaktor ausgebildet ist, und dem Verstärker mit variablem Verstärkungsfaktor der Filterschaltung für die Erzeugung eines Steuerausgangssignals verbunden sind, um den Verstärkungsfaktor des ersten oder zweiten Verstärkers zu steuern und zugleich die Sperrfrequenz der Filterschaltung einzustellen. Mit einer derartigen Schaltung wird jedoch kein von der Frequenzkennlinie unabhängiger Phasen-Frequenzgang erhalten.

Aus der JP-A-62-285 508 ist eine Schaltungsanordnung bekannt, mit der die Verstärkung bei einer bestimmten Frequenz ohne Veränderung der Phasencharakteristik und der Verzögerungscharakteristik variiert werden kann. Diese bekannte Schaltung enthält einen ersten, einen zweiten und einen dritten Differenzverstärker. Von einem Signaleingang wird ein Eingangssignal den nicht invertierenden Eingängen des ersten und des zweiten Differenzverstärkers zugeführt. Vom nicht invertierenden Ausgang des zweiten Differenzverstärkers wird ein Signal einerseits auf einen gegen Masse geschalteten Kondensator und andererseits an den nicht invertierenden Eingang des dritten Differenzverstärkers geleitet. Der invertierende Ausgangsanschluß des ersten Differenzverstärkers ist gemeinsam mit dem nicht invertierenden Ausgang des dritten Differenzverstärkers mit einem Signalausgang verbunden, der weiterhin mit allen invertierenden Eingängen der drei Differenzverstärker verbunden ist und außerdem über einen zweiten Kondensator mit dem Signaleingang verbunden ist. Über einen Steuerschaltkreis kann die Steilheit des ersten Differenzverstärkers gesteuert werden.

Bei dieser Schaltungsanordnung wird jedoch eine bestimmte Übertragungscharakteristik unveränderbar vorgegeben. Es sind keine Anregungen vorhanden, diese bekannte Schaltung für unterschiedliche Übertragungscharakteristiken, d.h. beispielsweise für Hochpaß- oder Tiefpaßverhalten, auszulegen. Außerdem wird durch die mehrfache Rückkopplung vom Ausgangsanschluß auf die verschiedenen Eingänge der Differenzverstärker eine nicht überschaubare Schwingneigung der Schaltung geschaffen.

Ferner sind aus der GB-OS 2,209,642 einige unterschiedliche Schaltungen bekannt, mit denen entweder ein Signal in einer Einstellbetriebsart modifiziert oder in einer anderen Betriebsart nicht beeinflußt werden soll, wobei in letzterer Betriebsart weder die Amplitude noch die Phase des Eingangssignals verändert werden sollen. In diesen Schaltungsanordnungen werden die Verstärkungsfaktoren der verschiedenen, eingesetzten Operationsverstärker in einem vorgegebenen Zusammenhang wechselseitig variiert, um die Verstärkungs- oder Phasencharakteristiken der einzelnen Schaltungen unabhängig voneinander zu modifizieren, oder sie werden in der anderen Betriebsart einander gleich oder gleich 1 gesetzt.

Die hier offenbarten Schaltungsanordnungen ähneln in ihrem Aufbau und in ihren Eigenschaften der Schaltung gemäß JP-A-62-285 508 und weisen entsprechend die gleichen Nachteile auf.

Steuerbare Filter sind auch aus DE-A-2 815 671 bekannt.

Die Erfindung hat die Aufgabe, eine Schaltungsanordnung der eingangs genannten Art zu schaffen, die sich stufenlos zwischen einem Allpaß und einem Tiefpaß bzw. Hochpaß vierter Ordnung umsteuern läßt, ohne daß dabei der Phasen-Frequenzgang, d.h. die Funktion der Phasendrehung des Signals durch die Schaltungsanordnung in Abhängigkeit von der Frequenz, verändert wird.

Diese Aufgabe wird erfindungsgemäß gelöst durch eine Übertragungsfunktion A zwischen dem Eingangssignal und dem Ausgangssignal mit einem Anteil

der Form

$$A = (C+(1-C) \cdot F - 2 \cdot C \cdot G) \cdot (C+(1-C) \cdot F),$$

wobei

$$F = FN = 1/(1+a \cdot s+b \cdot s^2)$$

oder

$$F = FH = b \cdot s^2/(1+a \cdot s+b \cdot s^2)$$

eine erste Filterfunktion wahlweise mit Hochpaß- oder Tiefpaßcharakteristik zweiter Ordnung und

$$G = a \cdot s/(1+a \cdot s+b \cdot s^2)$$

eine zweite Filterfunktion darstellt und wobei

    a, b konstante, reelle Faktoren sind,
    C ein reeller Faktor wählbarer Größe zwischen 0 und 1 einschließlich und
    s das Produkt der imaginären Einheit mit der Kreisfrequenz darstellt.

Bei den eingangs beschriebenen, aus dem Stand der Technik bekannten Verfahren und Schaltungen tritt regelmäßig der Effekt auf, daß eine Veränderung des Amplituden-Frequenzganges in einem frequenzmodulierten Signal ein Störgeräusch hervorruft, das durch die mit der Änderung des Amplituden-Frequenzganges verbundene Änderung der Gruppenlaufzeit als Funktion der Frequenz verursacht wird. Derartige Störgeräusche können sich z.B. beim Empfang und Verarbeiten eines Tonsignals als Knackgeräusche bemerkbar machen.

Der Erfindung liegt die Erkenntnis zugrunde, daß die beschriebenen Störgeräusche sehr wirkungsvoll und sicher beseitigt werden können, wenn die Schaltungsanordnung der gattungsgemäßen Art in der Weise gestaltet werden kann, daß ihr Phasen-Frequenzgang unabhängig von den beabsichtigten Variationen des Amplituden-Frequenzganges wird. Erfindungsgemäß wird eine Schaltungsanordnung geschaffen, die bei Änderung ihrer Grenzfrequenz einen unveränderbaren Phasen-Frequenzgang und damit eine unveränderte Gruppenlaufzeit aufweist. Damit können die beschriebenen Störgeräusche vermieden werden.

Die erfindungsgemäße Schaltungsanordnung ermöglicht den Aufbau sowohl von Tiefpässen als auch von Hochpässen vierter Ordnung, deren Übertragungsfunktion durch entsprechende Wahl und Dimensionierung der ersten und der zweiten Filterfunktion vorgegeben werden kann. Durch Einstellung des Wertes für den reellen Faktor C kann dann für die jeweils ausgewählte erste Filterfunktion, d.h. für die gewählte Auslegung der erfindungsgemäßen Schaltungsanordnung, der Amplituden-Frequenzgang, insbesondere die Bandbreite, der Übertragungsfunktion A zwischen dem Eingangssignal und dem Ausgangssignal eingestellt werden.

Gemäß einer weiteren Lösung enthält die erfindungsgemäße Schaltungsanordnung eine erste Teilschaltung, die eine erste Überlagerungsstufe umfaßt mit

-    einem ersten Additionseingang, der über ein erstes Koeffizientenglied mit dem Eingang gekoppelt ist,
-    einem zweiten Additionseingang, der über eine erste Filterstufe mit der ersten Filterfunktion F mit dem Eingang gekoppelt ist,
-    einem ersten Subtraktionseingang, der über ein zweites Koeffizientenglied mit dem zweiten Additionseingang gekoppelt ist,
-    einem zweiten Subtraktionseingang, der über eine Kaskadenschaltung, gebildet aus einer zweiten Filterstufe mit der zweiten Filterfunktion G und einem dritten Koeffizientenglied, mit dem Eingang gekoppelt ist und
-    einem ersten Zwischenergebnisausgang,

sowie eine zweite Teilschaltung, die eine zweite Überlagerungsstufe umfaßt

-    einem dritten Additionseingang, der über ein viertes Koeffizientenglied mit dem ersten Zwischenergebnisausgang gekoppelt ist,
-    einem vierten Additionseingang, der über eine dritte Filterstufe mit der ersten Filterfunktion F mit dem ersten Zwischenergebnisausgang gekoppelt ist,
-    einem dritten Subtraktionseingang, der über ein fünftes Koeffizientenglied mit dem vierten Additionseingang gekoppelt ist, und
-    einem zweiten Zwischenergebnisausgang, der mit dem Ausgang gekoppelt ist,

wobei im ersten, zweiten, vierten und fünften Koeffizientenglied die ihnen zuzuführenden Signale übereinstimmend mit dem Faktor C und im dritten Koeffizientenglied das ihm zuzuführende Signal mit dem Faktor $2 \cdot C$ multipliziert werden.

Diese Schaltungsanordnung weist einen modularen Aufbau auf, der durch die Auslegung der ersten und der dritten Filterstufe, die übereinstimmend die erste Filterfunktion F aufweisen, auf einfache Art an unterschiedliche Anforderungen der Signalverarbeitung angepaßt werden kann. Über die Koeffizientenglieder erfolgt dann die Einstellung des Amplituden-Frequenzganges, d.h. insbesondere der Bandbreite, und damit die stufenlose Umsteuerung zwischen dem Allpaßverhalten und dem Tiefpaß- bzw. Hochpaßverhalten. Dabei werden alle fünf Koeffizientenglieder gleichsinnig verstellt.

In einer anderen Weiterbildung können auch mehrere Übertragungsfunktionen der erfindungsgemäßen Form miteinander kaskadiert werden, wobei diese Übertragungsfunktionen identisch sein oder beliebig voneinander abweichen können. Die erfindungsgemäße Schaltungsanordnung umfaßt dazu bevorzugt wenigstens eine weitere, gemäß der Kaskadenschaltung der ersten und zweiten Teilschaltung aufgebaute Stufe, die in Kaskade zur Kaskadenschaltung der ersten und zweiten Teilschaltung angeordnet ist. In diesen weiteren Stufen mit zwar übereinstimmender Schaltungsstruktur, jedoch gegebenenfalls unterschiedlichen Filterfunktionen F von Stufe zu Stufe, können auch die Faktoren C von Stufe zu Stufe unterschiedlich einstellbar, gegebenenfalls auch fest gewählt sein.

Ausführungsbeispiele der erfindungsgemäßen Schaltungsanordnung sind in der Zeichnung, in deren Figuren übereinstimmende Elemente mit denselben Bezugszeichen versehen sind, dargestellt und werden im nachfolgenden näher beschrieben. Es zeigen

Fig. 1     ein Blockschaltbild einer Schaltungsanordnung nach der Erfindung,

Fig. 2     ein detailliertes Schaltbild einer weiteren Ausführungsform der Erfindung.

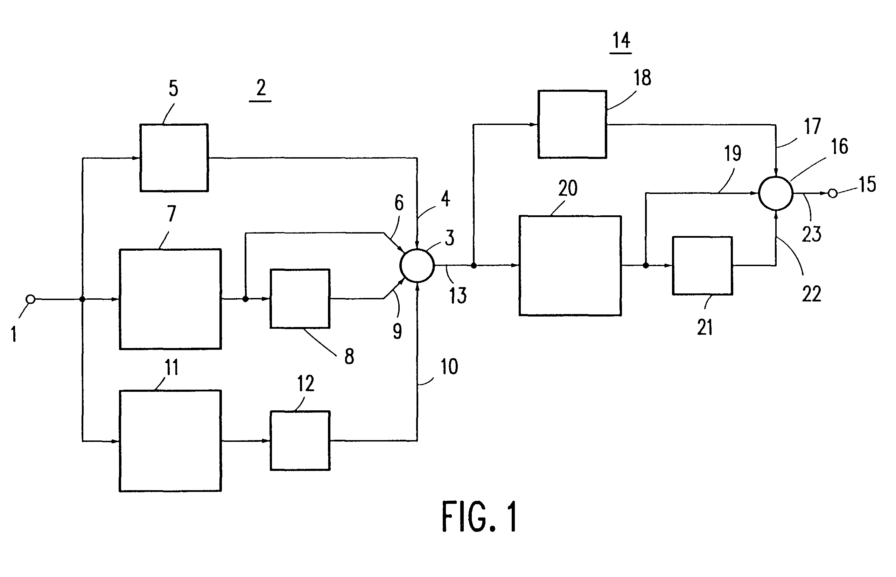

In Fig. 1 ist mit dem Bezugszeichen 1 ein Eingang bezeichnet, dem ein Eingangssignal zuführbar ist. Eine erste Teilschaltung 2 der Schaltungsanordnung nach Fig. 1 umfaßt eine erste Überlagerungsstufe 3 mit einem ersten Additionseingang 4, der über ein erstes Koeffizientenglied 5 mit dem Eingang 1 gekoppelt ist. Ein zweiter Additionseingang 6 der ersten Überlagerungsstufe 3 ist über eine Filterstufe 7, die eine erste Filterfunktion F aufweist, mit dem Eingang 1 und über ein zweites Koeffizientenglied 8 mit einem ersten Subtraktionseingang 9 der ersten Überlagerungsstufe 3 gekoppelt. Ferner ist ein zweiter Subtraktionseingang 10 der ersten Überlagerungsstufe 3 über eine Kaskadenschaltung, die aus einer zweiten Filterstufe 11 und einem dritten Koeffizientenglied 12 gebildet ist, mit dem Eingang 1 gekoppelt. Die zweite Filterstufe 11 weist eine zweite Filterfunktion G auf. Im ersten und zweiten Koeffizientenglied 5 bzw. 8 werden die ihnen zuzuführenden Signale mit einem reellen Faktor C multipliziert, im dritten Koeffizientenglied 12 mit dem Faktor 2·C. In der ersten Überlagerungsstufe 3 werden die über die Eingänge 4, 6, 9, 10 zugeführten Signale additiv überlagert, und zwar die Signale an den Additionseingängen 4, 6 mit positivem, die Signale an den Subtraktionseingängen 9, 10 mit negativem Vorzeichen. Ein aus dieser additiven Überlagerung resultierendes Zwischenergebnissignal wird an einem Zwischenergebnisausgang 13 der ersten Überlagerungsstufe 3 abgegeben.

Die Schaltungsanordnung nach Fig. 1 umfaßt weiterhin eine zweite Teilschaltung 14, die zur ersten Teilschaltung 2 in Kaskade zwischen dem Eingang 1 und einem Ausgang 15 angeordnet ist. Am Ausgang 15 kann ein Ausgangssignal der Schaltungsanordnung nach Fig. 1 abgegriffen werden. Die zweite Teilschaltung 14 umfaßt eine zweite Überlagerungsstufe 16 mit einem dritten Additionseingang 17, der über ein viertes Koeffizientenglied 18 mit dem ersten Zwischenergebnisausgang 13 gekoppelt ist. Ein vierter Additionseingang 19 der zweiten Überlagerungsstufe 16 ist über eine dritte Filterstufe 20, die die erste Filterfunktion F aufweist, mit dem ersten Zwischenergebnisausgang 13 und über ein fünftes Koeffizientenglied 21 mit einem dritten Subtraktionseingang 22 der zweiten Überlagerungsstufe 16 gekoppelt. Auch in der zweiten Überlagerungsstufe 16 werden die Signale an ihren Eingängen additiv verknüpft, und zwar die Signale an den Additionseingängen 17, 19 mit positivem und das Signal am Subtraktionseingang 22 mit negativem Vorzeichen. Das Verknüpfungsergebnis wird als Ausgangssignal an einem zweiten Zwischenergebnisausgang 23 der zweiten Überlagerungsstufe 16 abgegeben. Dieser zweite Zwischenergebnisausgang 23 ist mit dem Ausgang 15 verbunden. Die dem vierten und fünften Koeffizientenglied 18, 21 zugeführten Signale werden in diesen mit dem Faktor C multipliziert.

Die erste Filterfunktion F kann wahlweise als Tiefpaßfunktion FN oder als Hochpaßfunktion FH ausgeführt werden, und zwar jeweils als Funktion zweiter Ordnung. Die Tiefpaßfunktion FN, d.h. die erste Filterfunktion F mit Tiefpaßcharakteristik zweiter Ordnung erhält dann die Form

$$F = FN = 1/(1+a{\cdot}s+b{\cdot}s^2),$$

wohingegen die Hochpaßfunktion, d.h. die erste Filterfunktion F mit Hochpaßcharakteristik zweiter Ordnung, die Form

$$F = FH = b{\cdot}s^2/(1+a{\cdot}s+b{\cdot}s^2)$$

annimmt. Die zweite Filterfunktion G wird in jedem Fall dargestellt durch

$$G = a{\cdot}s/(1+a{\cdot}s+b{\cdot}s^2).$$

Dabei sind a und b konstante, reelle Faktoren, die sich aus der Dimensionierung der für die Filterstufen 7, 11, 20 benutzten Bauelemente ergeben. Die Größe s ist das Produkt der imaginären Einheit mit der Kreisfrequenz. Vorteilhaft können die Filterfunktionen F und G für eine bestimmte Dimensionierung der Schaltungsanordnung nach Fig. 1 mit identisch dimensionierten Bauteilen (Induktivität, Kapazität und Widerstand) aufgebaut werden, die zum Erlangen der Filterfunktionen FN, FH und G lediglich unterschiedlich zueinander angeordnet werden müssen. Der reelle Faktor C wird zwischen den Werten 0 und 1 einschließlich wählbar ausgeführt. Die Koeffizientenglieder 5, 8, 12, 18, 21 werden bei einer Verstellung des reellen Faktors C zueinander übereinstimmend eingestellt unter Berücksichtigung der Tatsache, daß das dritte Koeffizientenglied 12 den Faktor 2·C darstellt.

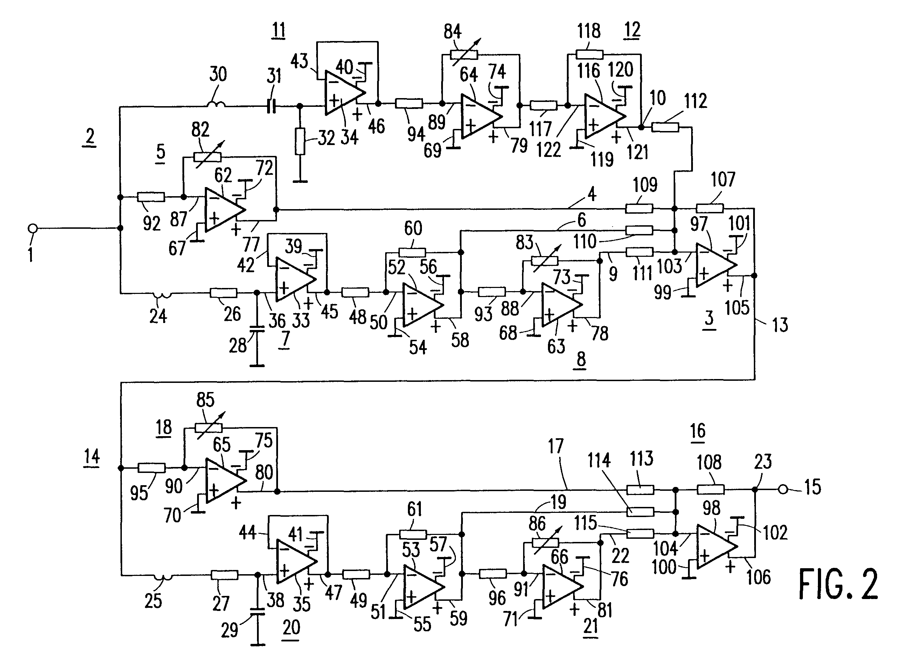

Fig. 2 zeigt ein detaillierteres Ausführungsbeispiel der erfindungsgemäßen Schaltungsanordnung mit als Tiefpaßfunktion FN ausgebildeter erster Filterfunktion F. Dazu umfassen die erste und die dritte Filterstufe 7 bzw. 20 je eine Reihenschaltung aus einer Induktivität 24 bzw. 25 mit einem ohmschen Widerstand 26 bzw. 27, die einerseits mit dem Eingang 1 bzw. dem ersten Zwischenergebnisausgang 13 verbunden und andererseits über eine Kapazität 28 bzw. 29 mit Masse gekoppelt ist. Die zweite Filterstufe 11 umfaßt eine Reihenschaltung aus einer Induktivität 30 mit einer Kapazität 31, die einerseits mit dem Eingang 1 verbunden und andererseits über einen ohmschen Widerstand 32 mit Masse gekoppelt ist. Dabei stimmen die Induktivitäten 24, 25, 30, die Kapazitäten 28, 29, 31 sowie die ohmschen Widerstände 26, 27, 32 in ihrer Dimensionierung jeweils überein.

Die drei Filterstufen 7, 11, 20 enthalten weiterhin je einen Differenzverstärker 33, 34 bzw. 35, die mit ihren nichtinvertierenden Eingängen 36, 37 bzw. 38 an die Verbindungspunkte zwischen dem ohmschen Widerstand 26 bzw. 27 und der Kapazität 28 bzw. 29 in der ersten bzw. dritten Filterstufe 7 bzw. 20 und im Fall der zweiten Filterstufe 11 zwischen der Kapazität 31 und dem ohmschen Widerstand 32 angeschlossen ist. Ein invertierender Ausgang 39, 40 bzw. 41 des Differenzverstärkers 33, 34 bzw. 35 ist mit Masse verbunden, wohingegen ein invertierender Eingang 42, 43 bzw. 44 des Differenzverstärkers 33, 34 bzw. 35 mit seinem nichtinvertierenden Ausgang 45, 46 bzw. 47 verbunden ist.

Die Verbindung des nichtinvertierenden Ausgangs 46 des Differenzverstärkers 34 der zweiten Filterstufe 11 mit dem invertierenden Eingang 43 bildet dabei einen Ausgang dieser zweiten Filterstufe 11. Dagegen ist bei der ersten und der dritten Filterstufe 7 bzw. 20 die entsprechende Verbindung des nichtinvertierenden Ausgangs 45 bzw. 47 des Differenzverstärkers 33 bzw. 35 mit dem invertierenden Eingang 42 bzw. 44 über einen Widerstand 48 bzw. 49 an einen invertierenden Eingang 50 bzw. 51 eines Differenzverstärkers 52 bzw. 53 geführt, dessen nichtinvertierender Eingang 54 bzw. 55 und dessen invertierender Ausgang 56 bzw. 57 an Masse gelegt sind und dessen nichtinvertierender Ausgang 58 bzw. 59 über je einen weiteren Widerstand 60 bzw. 61 mit dem invertierenden Eingang 50 bzw. 51 rückgekoppelt ist. Die letztgenannten Widerstände 48 und 60 bzw. 49 und 61 sind dabei bevorzugt gleich dimensioniert - insbesondere sind alle vier Widerstände 48, 49, 60, 61 untereinander gleich - , so daß die Differenzverstärker 52 bzw. 53 Impedanzwandlerstufen mit einem Verstärkungsfaktor von 1 bilden, die eine Entkopplung der ersten bzw. dritten Filterstufe 7 bzw. 20 mit den nachfolgenden Schaltungsteilen bewirken. Der nichtinvertierende Ausgang 58 bzw. 59 des Differenzverstärkers 52 bzw. 53 bildet dabei den Ausgang der jeweiligen Filterstufe 7 bzw. 20.

Jedes der fünf Koeffizientenglieder 5, 8, 12, 18 bzw. 21 enthält gemäß Fig. 2 einen Differenzverstärker 62, 63, 64, 65 bzw. 66, die identisch ausgebildet und beschaltet sind. Bei jedem der Differenzverstärker 62 bis 66 ist ein nichtinvertierender Eingang 67, 68, 69, 70 bzw. 71 sowie ein invertierender Ausgang 72, 73, 74, 75 bzw. 76 an Masse gelegt. Ein nichtinvertierender Ausgang 77, 78, 79, 80 bzw. 81 ist über einen einstellbaren, ohmschen Widerstand 82, 83, 84, 85 bzw. 86 auf einen invertierenden Eingang 87, 88, 89, 90 bzw. 91 rückgekoppelt, und ein dem jeweiligen Koeffizientenglied 5, 8, 12, 18 bzw. 21 zuzuführendes Signal wird dem zugehörigen, invertierenden Eingang 87, 88, 89, 90 bzw. 91 über einen Eingangswiderstand 92, 93, 94, 95 bzw. 96 zugeleitet. Entsprechend ist der Eingangswiderstand 92 des ersten Koeffizientengliedes 5 mit dem Eingang 1, der Eingangswiderstand 93 des zweiten Koeffizientengliedes 8 mit dem nichtinvertierenden Ausgang 58 des Differenzverstärkers 52 in der ersten Filterstufe 7, der Eingangswiderstand 94 des dritten Koeffizientengliedes 12 mit dem nichtinvertierenden Ausgang 46 des Differenzverstärkers 34 der zweiten Filterstufe 11, der Eingangswiderstand 95 des vierten Koeffizientengliedes 18 mit dem ersten Zwischenergebnisausgang 13 und der Eingangswiderstand 96 des fünften Koeffizientengliedes 21 mit dem nichtinvertierenden Ausgang 59 des Differenzverstärkers 53 der dritten Filterstufe 20 verbunden.

Die nichtinvertierenden Ausgänge 77, 78, 79, 80 bzw. 81 der Differenzverstärker 62, 63, 64, 65 bzw. 66 bilden entsprechend die Ausgänge des ersten, zweiten, dritten, vierten bzw. fünften Koeffizientengliedes 5, 8, 12, 18 bzw. 21. Dabei ist der nichtinvertierende Ausgang 77 des Differenzverstärkers 62 mit dem ersten Additionseingang 4, der nichtinvertierende Ausgang 78 des Differenzverstärkers 63 mit dem ersten Subtraktionseingang 9, der nichtinvertierende Ausgang 80 des Differenzverstärkers 65 mit dem dritten Additionseingang 17 und der nichtinvertierende Ausgang 81 des Differenzverstärkers 66 mit dem dritten Subtraktionseingang 22 verbunden. Die Maximalwerte der einstellbaren, ohmschen Widerstände 82, 83, 84, 85, 86 stimmen mit den Werten der Eingangswiderstände 92, 93, 94, 95 bzw. 96 überein. Dadurch können mit den Koeffizientengliedern 5, 8, 18, 21 sowie mit dem in vorstehend beschriebener Weise beschalteten Differenzverstärker 64 des dritten Koeffizientengliedes 12 Koeffizientenwerte kleiner oder gleich 1 eingestellt werden.

Die Überlagerungsstufen 3 und 16 enthalten ebenfalls je einen Differenzverstärker 97 bzw. 98, die mit ihren nichtinvertierenden Eingängen 99 bzw. 100 und ihren invertierenden Ausgängen 101 bzw. 102 mit Masse verbunden sind. Ein invertierender Eingang 103 bzw. 104 des Differenzverstärkers 97 bzw. 98 ist mit seinem nichtinvertierenden Ausgang 105 zw. 106 über einen Rückkopplungswiderstand 107 bzw. 108 verbunden. Der nichtinvertierende Ausgang 105 des Differenzverstärkers 97 bildet den ersten Zwischenergebnisausgang 13 der ersten Überlagerungsstufe 3, wohingegen der nichtinvertierende Ausgang 106 des Differenzverstärkers 98 den zweiten Zwischenergebnisausgang 23 der zweiten Überlagerungsstufe 16 und damit den Ausgang 15 der Schaltungsanordnung nach Fig. 2 für das Ausgangssignal bildet.

Der invertierende Eingang 103 des Differenzverstärkers 97 der ersten Überlagerungsstufe 3 ist über einen ersten Eingangswiderstand 109 mit dem nichtinvertierenden Ausgang 77 des Differenzverstärkers 62 des ersten Koeffizientengliedes 5, über einen zweiten Eingangswiderstand 110 mit dem nichtinvertierenden Ausgang 58 des Differenzverstärkers 52 in der ersten Filterstufe 7 und über einen dritten Eingangswiderstand 111 mit dem nichtinvertierenden Ausgang 78 des Differenzverstärkers 63 des zweiten Koeffizientengliedes 8 verbunden. Die Verbindung über den ersten Eingangswiderstand 109 der ersten Überlagerungsstufe 3 bildet den ersten Additionseingang 4, die Verbindung über den zweiten Eingangswiderstand 110 bildet den zweiten Additionseingang 6, und die Verbindung über den dritten Eingangswiderstand 111 bildet den ersten Subtraktionseingang 9. Entsprechend ist der invertierende Eingang 104 des Differenzverstärkers 98 der zweiten Überlagerungsstufe 16 über einen ersten Eingangswiderstand 113 mit dem nichtinvertierenden Ausgang 80 des Differenzverstärkers 65 des vierten Koeffizientengliedes 18, über einen zweiten Eingangswiderstand 114 mit dem nichtinvertierenden Ausgang 59 des Differenzverstärkers 53 der dritten Filterstufe 20 und über einen dritten Eingangswiderstand 115 mit dem nichtinvertierenden Ausgang 81 des Differenzverstärkers 66 des fünften Koeffizientengliedes 21 verbunden. Somit bildet die Verbindung über den ersten Eingangswiderstand 113 der zweiten Überlagerungsstufe 16 deren dritten Additionseingang 17, die Verbindung über den zweiten Eingangswiderstand 114 den vierten Additionseingang 19 und die Verbindung über den dritten Eingangswiderstand 115 den dritten Subtraktionseingang 22. Vorzugsweise sind der Rückkopplungswiderstand 107 und die Eingangswiderstände 109, 110, 111 der ersten Überlagerungsstufe sowie der Rückkopplungswiderstand 108 und die Eingangswiderstände 113, 114, 115 der zweiten Überlagerungsstufe 16 übereinstimmend dimensioniert. Dadurch weisen die Überlagerungsstufen 3 bzw. 16 bezüglich ihrer beschriebenen Ein- bzw. Ausgänge einen Verstärkungsfaktor von 1 auf. Vorzugsweise sind alle Eingangswiderstände 109, 110, 111, 113, 114, 115 sowie die Rückkopplungswiderstände 107, 108 übereinstimmend dimensioniert. Der zweite Subtraktionseingang 10 der ersten Überlagerungsstufe 3 wird durch eine Verbindung des invertierenden Eingangs 103 des Differenzverstärkers 97 über einen vierten Eingangswiderstand 112 gebildet. Im Ausführungsbeispiel nach Fig. 2 weist dieser vierte Eingangswiderstand 112 nur den halben Widerstandswert der Eingangswiderstände 109 bis 111 des Differenzverstärkers 97 der ersten Überlagerungsstufe 3 auf. Im Zusammenwirken mit dem Rückkopplungswiderstand 107 wird damit für die über den vierten Eingangswiderstand 112 eingespeiste Signalspannung ein Verstärkungsfaktor von 2 erzielt. Zusammen mit dem Faktor C des Differenzverstärkers 64 aus dem dritten Koeffizientenglied 12 ergibt sich damit der durch dieses dritte Koeffizientenglied 12 zu erzielende Multiplikationsfaktor von 2·C. Das dritte Koeffizientenglied 12 weist eine Entkopplungs- und Impedanzwandlerstufe auf, über die das Signal vom nichtinvertierenden Ausgang 79 des Differenzverstärkers 64 an den zweiten Subtraktionseingang 10 gekoppelt wird und die in Übereinstimmung mit den entsprechenden Stufen 48, 50, 52, 54, 56, 58, 60 bzw. 49, 51, 53, 55, 57, 59, 61 einen zweiten Differenzverstärker 116, einen zweiten Widerstand 117 und einen zweiten Rückkopplungswiderstand 118 aufweist. Ein nichtinvertierender Eingang 119 und ein invertierender Ausgang 120 des zweiten Differenzverstärkers 116 des dritten Koeffizientengliedes 12 sind mit Masse verbunden, wogegen ein nichtinvertierender Ausgang 121 über den zweiten Rückkopplungswiderstand 118 mit einem invertierenden Eingang 122 gekoppelt ist. Der invertierende Eingang 122 des zweiten Differenzverstärkers 116 ist über den zweiten Widerstand 117 mit dem nichtinvertierenden Ausgang 79 des Differenzverstärkers 64 verbunden, und der nichtinvertierende Ausgang 121 bildet den zweiten Subtraktionseingang 10. Bei übereinstimmender Dimensionierung des zweiten Widerstands 117 und des zweiten Rückkopplungswiderstands 118 weist die Entkopplungs- bzw. Impedanzwandlerstufe mit dem zweiten Differenzverstärker 116 ebenfalls eine Verstärkung von 1 auf.

In einer Abwandlung der in Fig. 2 skizzierten Schaltungsanordnung, insbesondere der darin gezeigten Ausgestaltung des dritten Koeffizientengliedes 12, können der einstellbare, ohmsche Widerstand 84 und der zweite Rückkopplungswiderstand 118 miteinander vertauscht werden. Auch können in einer anderen Abwandlung der zweite Widerstand 117 des dritten Koeffizientengliedes 12 und der vierte Eingangswiderstand 112 der ersten Überlagerungsstufe 3 miteinander vertauscht werden. Im letzteren Fall erhält man eine Schaltungsanordnung, die sich unmittelbar an das Blockschaltbild von Fig. 1 anlehnt, indem die erste Überlagerungsstufe 3 bezüglich aller ihrer Eingänge 4, 6, 9 bzw. 10 einen Verstärkungsfaktor von 1 aufweist und das dritte Koeffizientenglied 12 aus zwei in Kaskade geschalteten Teilen besteht, die durch die Differenzverstärker 64 bzw. 116 und ihre Beschaltung gegeben sind und die die Verstärkungsfaktoren C (Differenzverstärker 64) und 2 (zweiter Differenzverstärker 116) aufweisen; zusammen somit den Verstärkungsfaktor 2·C.

Die einzelnen Differenzverstärker 33, 34, 35, 52, 53, 62, 63, 64, 65, 66, 97, 98 und 116 sind gemäß der vorstehenden Beschreibung in der Weise invertierend bzw. nichtinvertierend beschaltet und miteinander verbunden, daß insgesamt die geforderten Polaritäten bzw. Vorzeichen der zu bearbeitenden und verknüpfenden Signale entsprechend den vorzunehmenden Additionen bzw. Subtraktionen entstehen.

In einer Abwandlung des Ausführungsbeispiels nach Fig. 2 können anstelle der Induktivitäten 24, 25, der Kapazitäten 28, 29 und der ohmschen Widerstände 26, 27 in der ersten und der dritten Filterstufe 7 bzw. 20 auch andere Elemente eingefügt werden, die statt einer Tiefpaßcharakteristik zweiter Ordnung eine Hochpaßcharakteristik zweiter Ordnung als erste Filterfunktion F aufweisen. Anstelle der Filterfunktion

$$F = FN = 1/(1+a \cdot s+b \cdot s^2)$$

erhält man dann die Filterfunktion

$$F = FH = b \cdot s^2/(1+a \cdot s+b \cdot s^2).$$

Diese Abwandlung der ersten Filterfunktion F kann in einfacher Weise durch Vertauschen der Anordnung der Induktivität 24 bzw. 25 mit der Kapazität 28 bzw. 29 erhalten werden, so daß die jeweilige Kapazität 28 bzw. 29 jetzt mit dem Eingang 1 bzw. dem ersten Zwischenergeb- nisausgang 13 verbunden ist, wohingegen die Induktivität 24 bzw. 25 jetzt gegen Masse geschaltet wird. Bei einem derartigen Tausch der Anordnung der Bauelemente können die Induktivität 30, die Kapazität 31 und der ohmsche Widerstand 32 der zweiten Filterstufe 11 mit der zweiten Filterfunktion G unverändert bleiben.

Für eine Einstellung des Amplituden-Frequenzganges der Schaltungsanordnung nach Fig. 2 sind die einstellbaren, ohmschen Widerstände 82 bis 86 gleichsinnig zu verstellen. dies ist in Fig. 2 aus Gründen der Übersichtlichkeit nicht explizit dargestellt.

In einer nicht dargestellten Abwandlung der Ausführungsbeispiele nach den Fig. 1 oder 2 können die darin dargestellten Schaltungsanordnungen mit einer oder mehreren weiteren Stufen, die ähnlich oder identisch aufgebaut sein können, in Kaskade geschaltet werden. Dadurch sind Kombinationen mit weiteren Signalverarbeitungen bzw. -formungen möglich, durch die auch andersartige und kompliziertere Filtercharakteristiken erhalten werden können. Im einfachsten Fall werden die Schaltungsanordnungen nach Fig. 1 oder 2 mit zu sich identischen Anordnungen kaskadiert, wodurch z.B. Tiefpaßcharakteristiken oder Hochpaßcharakteristiken höherer Ordnungen erhalten werden können.

## Patentansprüche

1. Schaltungsanordnung mit einem einstellbaren Amplituden-Frequenzgang zwischen einem Eingang (1), dem ein Eingangssignal zuführbar ist, und einem Ausgang (15) zum Abgreifen eines Ausgangssignals,
gekennzeichnet durch eine Übertragungsfunktion A zwischen dem Eingangssignal und dem Ausgangssignal mit einem Anteil der Form

$$A = (C+(1-C) \cdot F - 2 \cdot C \cdot G) \cdot (C+(1-C) \cdot F),$$

wobei F eine erste Filterfunktion wahlweise mit Tiefpaßcharakteristik zweiter Ordnung

$$F = FN = 1/(1+a \cdot s+b \cdot s^2)$$

oder mit
Hochpaßcharakteristik zweiter Ordnung

$$F = FH = b \cdot s^2/(1+a \cdot s+b \cdot s^2)$$

und G eine zweite Filterfunktion mit Bandpaßcharakteristik zweiter Ordnung

$$G = a \cdot s/(1+a \cdot s+b \cdot s^2)$$

darstellt und wobei

a, b konstante, reelle Faktoren sind,
C ein reeller Faktor wählbarer Größe zwischen 0 und 1 einschließlich und
s das Produkt der imaginären Einheit mit der Kreisfrequenz darstellt.

2. Schaltungsanordnung nach Anspruch 1, gekennzeichnet durch eine erste Teilschaltung (2), die eine erste Überlagerungsstufe (3) umfaßt mit

- einem ersten Additionseingang (4), der über ein erstes Koeffizientenglied (5) mit dem Eingang (1) gekoppelt ist,
- einem zweiten Additionseingang (6), der über eine erste Filterstufe (7) mit einer ersten Filterfunktion F, die wahlweise eine Hochpaß- oder Tiefpaßcharakteristik zweiter Ordnung aufweist, mit dem Eingang (1) gekoppelt ist,
- einem ersten Subtraktionseingang (9), der über ein zweites Koeffizientenglied (8) mit dem zweiten Additionseingang (6) gekoppelt ist,
- einem zweiten Subtraktionseingang (10), der über eine Kaskadenschaltung, gebildet aus einer zweiten Filterstufe (11) mit einer zweiten Filterfunktion G, die eine Bandpaßcharakteristik zweiter Ordnung aufweist, und einem dritten Koeffizientenglied (12), mit dem Eingang (1) gekoppelt ist und
- einem ersten Zwischenergebnisausgang (13),

sowie eine zweite Teilschaltung (14), die eine zweite Überlagerungsstufe (16) umfaßt mit

- einem dritten Additionseingang (17), der über ein viertes Koeffizientenglied (18) mit dem ersten Zwischenergebnisausgang (13) gekoppelt ist,
- einem vierten Additionseingang (19), der über eine dritte Filterstufe (20) mit der ersten Filterfunktion F mit dem ersten Zwischenergebnisausgang (13) gekoppelt ist,
- einem dritten Subtraktionseingang (22), der über ein fünftes Koeffizientenglied (21) mit dem vierten Additionseingang (19) gekoppelt ist, und
- einem zweiten Zwischenergebnisausgang (23), der mit dem Ausgang (15) gekoppelt ist,

wobei im ersten, zweiten, vierten und fünften Koeffizientenglied (5. 8, 18, 21) die ihnen zuzuführenden Signale übereinstimmend mit einem reellen Faktor C wählbarer Größe zwischen 0 und 1 einschließlich und im dritten Koeffizientenglied (12) das ihm zuzuführende Signal mit dem Faktor $2 \cdot C$ multipliziert werden.

3. Schaltungsanordnung nach Anspruch 2, gekennzeichnet durch wenigstens eine weitere, gemäß der Kaskadenschaltung der ersten und zweiten Teilschaltung (2, 14) aufgebaute Stufe, die in Kaskade zur Kaskadenschaltung der ersten und zweiten Teilschaltung (2, 14) angeordnet ist.

**Claims**

1. A circuit arrangement with an adjustable amplitude-frequency response between an input (1), which is arranged to receive an input signal, and an output (15) for taking off an output signal, characterised by a transfer function A between the input signal and the output signal with a component complying with

$$A = (C+(1-C) \cdot F - 2 \cdot C \cdot G) \cdot (C+(1-C) \cdot F),$$

where F represents a first filter function at option with a second-order low-pass characteristic

$$F = FN = 1/(1+a \cdot s+b \cdot s^2),$$

or with a second-order high-pass characteristic

$$F = FH = b \cdot s^2/(1+a \cdot s+b \cdot s^2)$$

and G represents a second filter function G with a second-order band-pass characteristic $G = a \cdot s/(1+a \cdot s+b \cdot s^2)$
and where a, b are constant real factors,

C is a real factor whose magnitude is selectable between 0 and 1 inclusive, and
s is the product of the imaginary unit and the angular frequency.

2. A circuit arrangement as claimed in claim 1, characterised by a first circuit section (2) comprising a first summing stage (3) having

- a first add input (4) coupled to the input (1) *via* a first coefficient section (5),
- a second add input (6) coupled to the input (1) *via* a filter stage (7) having a first filter function F which optionally has a second-order high-pass or low-pass characteristic,
- a first subtract input (9) coupled to the second add input (6) *via* a second coefficient section (8),
- a second subtract input (10) coupled to the input (1) *via* a cascade arrangement of a second filter stage (11) having a second filter function G, which has a second-order band-pass characteristic, and a third coefficient section (12), and
- a first intermediate-result output (13), as well as a second circuit section (14) comprising a second summing stage (16) having
- a third add input (17) coupled to the first intermediate-result output (13) *via* a fourth coefficient section (18),
- a fourth add input (19) coupled to the first intermediate-result output (13) *via* a third filter stage (20) having the first filter function F,
- a third subtract input (22) coupled to the fourth add input (19) *via* a fifth coefficient section (21), and
- a second intermediate-result output (23) coupled to the output (15), the signals applied to the first, the second, the fourth and the fifth coefficient section (5, 8, 18, 21) being multiplied by a real factor C in these sections, the magnitude of this factor being selectable between 0 and 1 inclusive, and the signal applied to the third coefficient section (12) being multiplied by the factor $2 \cdot C$ in this section.

3. A circuit arrangement as claimed in claim 2, characterised by at least one further stage of the same construction as the cascade of the first and the second circuit section (2, 14), which further stage is cascaded with the cascade of the first and the second circuit section (2, 14).

**Revendications**

1. Circuit avec une réponse de fréquence réglable entre une entrée (1) à laquelle un signal d'entrée peut être amené et une sortie (15) en vue de prélever un signal de sortie,

   caractérisé par une fonction de transmission A entre le signal d'entrée et le signal de sortie avec une composante de forme:

   A= (C + (1-C). F-2-C.G).(C+(1-C).F),

   dans laquelle F= FN = 1/(1 +a + s + b. $s^2$) ou F = FH = $b.s^2$/(1 + a. s + $b.s^2$), une première fonction de filtrage au choix avec une caractéristique passe-haut ou passe-bas de deuxième ordre ou avec une caractéristique passe-haut de deuxième ordre

   $$F = FH = b.s^2/(1+a.s+b.s^2)$$

   et

   $$G = a.s/(1 + a.s+ b.s^2)$$

   représentant une deuxième fonction de filtrage avec une caractéristique de bande passante de deuxième ordre

   $$G = a.s/(1+a.s+b.s^2)$$

   a, b étant des facteurs réels constants,
   C un facteur réel de grandeur variable entre 0 et 1 inclus et
   s le produit de l'unité imaginaire avec la fréquence de circuit.

2. Circuit selon la revendication 1,
   caractérisé par un premier circuit partiel (2) qui comprend un premier étage de superposition (3) avec

   - une première entrée d'addition (4) qui est couplée par l'intermédiaire d'un premier organe de coefficient (5) à l'entrée (1),
   - une deuxième entrée d'addition (6) qui est couplée par l'intermédiaire d'un premier étage de filtrage (7) avec une première fonction de filtrage F qui présente au choix une caractéristique passe-bas ou passe-haut de deuxième ordre à l'entrée (1),
   - une première entrée de soustraction (9) qui est couplée par l'intermédiaire d'un deuxième organe de coefficient (8) avec la deuxième entrée d'addition (6);
   - une deuxième entrée de soustraction (10) qui est couplée par l'intermédiaire d'un circuit en cascade formé d'un deuxième étage de filtrage (11) avec la deuxième fonction de filtrage G et d'un troisième organe de coefficient (12) avec l'entrée (1) et
   - une première sortie de résultat intermédiaire (13) ainsi qu'un deuxième circuit partiel (14) qui comprend un deuxième étage de superposition (16) avec
   - une troisième entrée d'addition (17) qui est couplée par l'intermédiaire d'un quatrième organe de coefficient (18) à la première sortie de résultat intermédiaire (13),
   - une quatrième entrée d'addition (19) qui est couplée par l'intermédiaire d'un troisième étage de filtrage (20) à la première fonction de filtrage F avec la première sortie de résultat intermédiaire (13),
   - une troisième entrée de soustraction (22) qui est couplée par l'intermédiaire d'un cinquième organe de coefficient (21) à la quatrième entrée d'addition (19) et
   - une deuxième sortie de résultat intermédiaire (23) qui est couplée à la sortie (15),

   dans les premier, deuxième, quatrième et cinquième organes de coefficient (5, 8, 18, 21), les signaux qui leur sont amenés étant multipliés en conséquence par un facteur réel C de grandeur variable de 0 à 1 inclus et dans le troisième organe de coefficient (12) le signal qui lui est amené étant multiplié par le facteur 2.C.

3. Circuit selon la revendication 2,
   caractérisé par au moins un autre étage conçu conformément au montage en cascade des premier et deuxième circuits partiels (2, 14) qui est disposé en cascade par rapport au montage en cascade des premier et deuxième montages partiels (2, 14).

FIG. 1

FIG. 2

EP 0 678 978 B1